# EUROPÄISCHE PATENTSCHRIFT

(11) **EP 1 576 704 B1**
(45) Veröffentlichungstag und Bekanntmachung des Hinweises auf die Patenterteilung: **04.04.2007**
(21) Anmeldenummer: 03785500.4
(22) Anmeldetag: 06.11.2003
(51) Int. Cl.: H01S 5/024, H01S 5/40

(54) **LASERDIODENBARREN MIT PARALLEL GESCHALTETER DIODE ZUR ELEKTRISCHEN ÜBERBRÜCKUNG DES LASERDIODENBARRENS IM FEHLERFALL**
LASER DIODE BAR PROVIDED WITH A PARALLEL CONNECTED DIODE FOR BRIDGING SAID LASER DIODE BAR IN CASE OF FAILURE
BARRE DE DIODES LASER A DIODE COUPLEE EN PARALLELE EN VUE DU PONTAGE ELECTRIQUE DE LA BARRE DE DIODES LASER EN CAS DE PANNE

(30) Priorität: 27.12.2002 DE 10261309; 14.02.2003 DE 10306312
(43) Veröffentlichungstag der Anmeldung: 21.09.2005
(73) Patentinhaber: Osram Opto Semiconductors GmbH, 93049 Regensburg (DE)
(72) Erfinder: EBERHARD, Franz, 93059 Regensburg (DE); HERRMANN, Gerhard, 93170 Bernhardswald (DE); MARIC, Josip, 93161 Sinzing (DE); SCHWIND, Michael, 93161 Sinzing (DE); BEHRINGER, Martin, 93051 Regensburg (DE); BEHRES, Alexander, 93309 Kelheim (DE)
(74) Vertreter: Epping - Hermann - Fischer
(86) Internationale Anmeldenummer: PCT/DE2003/003683
(87) Internationale Veröffentlichungsnummer: WO 2004/062051

(56) Entgegenhaltungen:
- EP-A- 0 405 952
- WO-A-03/075423
- US-A- 5 459 328
- US-A1- 2002 043 943
- US-B1- 6 348 358
- PATENT ABSTRACTS OF JAPAN vol. 010, no. 061 (E-387), 11. März 1986 (1986-03-11) & JP 60 211992 A (HITACHI SEISAKUSHO KK), 24. Oktober 1985 (1985-10-24)
- PATENT ABSTRACTS OF JAPAN vol. 016, no. 307 (E-1229), 7. Juli 1992 (1992-07-07) & JP 04 084476 A (CANON INC), 17. März 1992 (1992-03-17)

## Beschreibung

Die Erfindung betrifft ein Laserdiodenbauelement nach dem Oberbegriff des Patentanspruches 1 und eine elektronische Schaltungsanordnung gemäß dem Oberbegriff des Patentanspruches 11. Sie bezieht sich insbesondere auf ein Laserdiodenbauelement bzw. auf eine Schaltungsanordnung mit einem bzw. mehreren Hochleistungslaserdiodenbarren.

Beim Ausfall eines Laserdiodenbarrens kann es zur Unterbrechung des Stromflusses über den Laserdiodenbarren kommen. In einer Schaltungsanordnungen mit einer Mehrzahl von seriell zueinander verschalteten Laserdiodenbarren oder Laserdiodenbarrenmodulen führt dies zum Komplett-Ausfall aller Laserdiodenbarren beziehungsweise -module der betroffenen Serie. Zur Behebung des Ausfalls wird bislang üblicherweise die gesamte Serie mit dem ausgefallenen Laserdiodenbarren ausgetauscht.

Laserdioden unit Überbrückungselementen aus US-A-5 459 328 bekannt. Laserdiodenbaren mit einem Überbrückungselement auf eine gemeinsamen wärmesenke sind in US-B-6 348 358 offenbart.

Der vorliegenden Erfindung liegt die Aufgabe zugrunde, einen Laserdiodenbarren bzw. eine Schaltungsanordnung bereitzustellen, bei der es bei einem Ausfall eines einzelnen Laserdiodenbarrens bzw. -moduls nicht zum Komplett-Ausfall der gesamten Serie von Laserdiodenbarren bzw. -modulen kommt.

Diese Aufgabe wird mit einem Laserdiodenbarren mit den Merkmalen des Patentanspruches 1 bzw. mit einer Schaltungsanordnung mit den Merkmalen des Patentanspruches 10 gelöst.

Bevorzugte Ausführungsformen und vorteilhafte Weiterbildungen der Erfindung sind in den abhängigen Ansprüchen 2 bis 9 und 11 bis 18 angegeben.

Die erfindungsgemäße Anordnung sieht vor, ein Überbrückungselement, insbesondere in Form eines Halbleiterbauelements so parallel zu einem Laserdiodenbarren zu schalten, dass beim Ausfall des Laserdiodenbarrens, der ein Unterbrechen oder eine starke Verringerung des Stromflusses über ihn zur Folge hat, das Überbrückungselement durchschaltet und den ausgefallenen Laserdiodenbarren elektrisch überbrückt. An Stelle des Halbleiterbauelements kann auch ein mechanisches Element, beispielsweise ein Relais eingesetzt werden. Das Überbrückungselement muß derart ausgestaltet sein, dass es bei ordnungsgemäßen Betrieb des Laserdiodenbarren hinreichend hochohmig ist und dass es bei schadhaftem hochohmigen Laserdiodenbarren aufgrund des erhöhten Spannungsabfalls durchschaltet und den Laserdiodenbarren elektrisch überbrückt, so dass die übrigen Laserdiodenbarren einer Serienschaltung nach wie vor mit Strom versorgt bleiben.

Das Überbrückungselement kann ein einziges geeignetes elektrisches Element (zum Beispiel Diode etc. (siehe weiter unten)) oder eine Mehrzahl von parallel oder seriell verschalteten elektrischen Elementen aufweisen. Ebenso können mehrere Überbrückungselemente in serieller oder paralleler Verschaltung zum Einsatz kommen.

Ein bevorzugtes Schaltelement ist eine Diode, insbesondere eine AlGaAs-Diode, deren Diffusionsspannung (auch Schwellen- oder Schleusenspannung genannt) höher als die Betriebsspannung des Diodenlasers ist. Vorzugsweise ist die Diffusionsspannung mindestens 200 mV höher als die Betriebsspannung des Diodenlasers. Dies gewährleistet vorteilhafterweise einerseits einen sicheren Betrieb eines ordnungsgemäß funktionierenden Laserdiodenbarrens auch bei Spannungsschwankungen und andererseits ein sicheres Schalten auf Durchlass bei einem Ausfall des zugehörigen Laserdiodenbarrens.

Der Laserdiodenbarren und das zugehörige Überbrückungselement sind auf einer gemeinsamen Wärmesenke aufgebracht, das Überbrückungselement ist mittels eines ersten Verbindungsmittels auf der Wärmesenke befestigt und der Laserdiodenbarren ist mittels eines zweiten Verbindungsmittels auf der Wärmesenke befestigt. Der Schmelzpunkt des ersten Verbindungsmittels liegt bei einer höheren Temperatur als der des zweiten Verbindungsmittels. Dadurch wird vorteilhafterweise vermieden, dass bei einer Montage des Überbrückungselements auf die Wärmesenke bevor der Laserdiodenbarren montiert wird die Verbindung zwischen Überbrückungselement und Wärmesenke während der Montage des Laserdiodenbarrens geschädigt wird.

Bevorzugt wird das Überbrückungselement mittels eines Hartlotes und der Laserdiodenbarren mittels eines Weichlotes auf der Wärmesenke befestigt.

Die Wärmesenke ist beispielsweise ein metallischer Kühlkörper oder ein mit einer Mikrokanalkühlerstruktur versehener Metallträger, durch den eine Kühlflüssigkeit gepumpt wird. Laserdiodenbarren und Überbrückungselement können aber auch auf ein gemeinsames wärmeleitendes Leadframe montiert sein, das eine hinreichende Wärmeableitung vom Laserdiodenbarren gewährleistet.

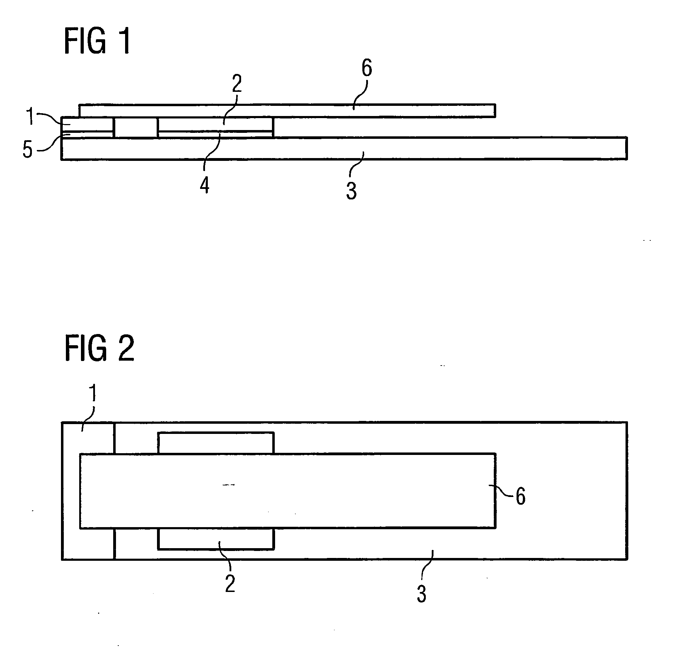

Weitere vorteilhafte Ausgestaltungen und Weiterbildungen des erfindungsgemäßen Laserdiodenbauelements bzw. der erfindungsgemäßen Schaltungsanordnung ergeben sich aus dem im Folgenden in Verbindung mit den Figuren 1 und 2 erläuterten Ausführungsbeispiel. Es zeigen:
Figur 1 eine Schnittansicht durch das Ausführungsbeispiel, und
Figur 2 eine Draufsicht auf das Ausführungsbeispiel.

Bei dem Ausführungsbeispiel ist ein Laserdiodenbarren 1 zusammen mit einer AlGaAs-Diode 2 auf einem gemeinsamen metallischen Träger 3 montiert. Der Laserdiodenbarren 1 ist mittels eines Weichlotes 5 (zum Beispiel Indium-Lot) und die AlGaAs-Diode 2 ist mittels eines Hartlotes 4 (zum Beispiel AuSn-Lot) auf dem Träger 3 befestigt. Der Träger 3 ist eine Wärmesenke und stellt jeweils einen ersten elektrischen Anschluß des Laserdiodenbarrens 1 und der AlGaAs-Diode 2 dar.

Die AlGaAs-Diode 2 ist derart ausgelegt, dass deren Diffusionsspannung etwa 200 mV über der Betriebsspannung des Laserdiodenbarrens 1 liegt.

Ein Anschlußstreifen 6 überspannt den Laserdiodenbarren 1 und die AlGaAs-Diode 2 und ist mit diesen mittels eines metallischen Lotes elektrisch leitend verbunden. Der Anschlußstreifen 6 stellt jeweils einen zweiten elektrischen Anschluß des Laserdiodenbarrens 1 und der AlGaAs-Diode 2 dar.

Im Herstellungsprozess eines solchen Laserdiodenbauelements wird zunächst die AlGaAs-Diode 2 mittels des Hartlotes 4 auf dem Träger 3 befestigt. Danach wird der metallische Träger 3 mit Indium bedampft und dadurch für die Montage des Laserdiodenbarrens 1 vorbereitet. Nachfolgend wird der Laserdiodenbarren 1 mittels Weichlöten auf dem Träger 3 aufgebracht. Da die Indium-Lötung bei wesentlich geringerer Temperatur erfolgt als die Hartlötung der AlGaAs-Diode 2, besteht nicht das Risiko, dass beim Montieren des Laserdiodenbarrens 1 die Verbindung zwischen Träger 3 und AlGaAs-Diode 2 wieder erweicht.

Fällt bei der oben beschriebenen Anordnung der Laserdiodenbarren 1 aus und läßt dieser infolgedessen keinen Stromfluß mehr zu, steigt die Spannung zwischen Kathode (Träger) und Anode (Anschlußstreifen) stark an bis die Paralleldiode 2 auf Durchlass schaltet und den Laserdiodenbarren 1 im Wesentlichen kurzschließt.

Ein Laserdiodenbauelement gemäß dem Ausführungsbeispiel hat den besonderen Vorteil, dass es klein und integrierbar ist.

Bei einer erfindungsgemäßen Schaltungsanordnung mit Laserdiodenbauelementen gemäß dem Ausführungsbeispiel ist eine Mehrzahl solcher Laserdiodenbauelemente und damit eine Mehrzahl von Laserdiodenbarren in Serie zueinander verschaltet.

An Stelle der AlGaAs-Diode 2 kann eine hinsichtlich der Schaltspannung geeignete Zenerdiode, ein entsprechend geeigneter Triac (überkopf), eine Mehrzahl von seriell verschalteten Si-Dioden oder ein mechanischer Schalter/eine mechanische Sicherung (zum Beispiel ein Überspannungsableiter, eine Feder auf Lotkugel oder ein Bimetallschalter) eingesetzt werden.

Ebenso anwendbar ist eine Anordnung in FET-Technologie, Sip-MOS-Technologie oder CoolMOS-Technologie. Ein besonderer Vorteil dieser Technologie besteht darin, dass eine intelligente Schaltungsanordnung mit kleiner Verlustleistung realisierbar ist und dass der Zustand der zugehörigen Laserdiode auch per Fernabfrage erkennbar ist. Alternativ ist auch die Verwendung eines Thyristors, eines Bipolar-Transistors, eines Relais oder eines manuellen Schalters als Überbrückungselement denkbar.

Diese Patentanmeldung beansprucht die Priorität der deutschen Patentanmeldungen 102 61 309.5 vom 27. Dezember 2002 und 103 06 312.9 vom 14. Februar 2003.

## Patentansprüche

1. Laserdiodenbauelement mit einem Laserdiodenbarren (1), an dem im Betrieb eine bestimmte Betriebsspannung anliegt, wobei
- dem Laserdiodenbarren (1) ein Überbrückungselement (2) parallelgeschaltet ist, das bei Anliegen der bestimmten Betriebsspannung am zugehörigen Laserdiodenbarren (1) einen geringeren Strom durchläßt als der Laserdiodenbarren (1) oder keinen Strom durchläßt und das in einen derart niederohmigen Zustand umschaltet, dass der Laserdiodenbarren (1) überbrückt wird, sobald der Spannungsabfall am Laserdiodenbarren (1) die bestimmte Betriebsspannung um einen vorgegebenen Spannungswert überschreitet,
- der Laserdiodenbarren (1) und das zugehörige Überbrückungselement (2) auf einer gemeinsamen Wärmesenke (3) aufgebracht sind, und
- das Überbrückungselement (2) mittels eines ersten Verbindungsmittels (4) auf der wärmesenke (3) befestigt ist und der Laserdiodenbarren (1) mittels eines zweiten Verbindungsmittels (5) auf der Wärmesenke (3) befestigt ist,
**dadurch gekennzeichnet, dass**
der Schmelzpunkt des ersten Verbindungsmittels (4) bei einer höheren Temperatur liegt als der des zweiten Verbindungsmittels (5).

2. Laserdiodenbauelement nach Anspruch 1,
**dadurch gekennzeichnet, dass**
das Überbrückungselement (2) in den den Laserdiodenbarren (1) überbrückenden Zustand umschaltet, sobald die am Überbrückungselement anliegende Spannung mindestens 200 mV höher ist als die bestimmte Betriebsspannung des zugehörigen Laserdiodenbarrens.

3. Laserdiodenbauelement nach Anspruch 1 oder 2,
**dadurch gekennzeichnet, dass**
das Überbrückungselement (2) mindestens eine Diode aufweist, die bei Anliegen der bestimmten Betriebsspannung an dem zugehörigen Laserdiodenbarren (1) in Durchlassrichtung gepolt ist und deren Diffusionsspannung mindestens 200 mV höher ist als die Betriebsspannung des zugehörigen Laserdiodenbarrens (1).

4. Laserdiodenbauelement nach Anspruch 2 oder 3,
**dadurch gekennzeichnet, dass**
das Überbrückungselement (2) eine Diode auf der Basis von AlGaAs-Halbleitermaterial aufweist.

5. Laserdiodenbauelement nach Anspruch 2 oder 3,
**dadurch gekennzeichnet, dass**
das Überbrückungselement (2) eine Serienschaltung von mehreren Dioden aufweist.

6. Laserdiodenbauelement nach Anspruch 5,
**dadurch gekennzeichnet, dass**
die Serienschaltung drei Si-Dioden aufweist.

7. Laserdiodenbauelement nach Anspruch 2,
**dadurch gekennzeichnet, dass**
das Überbrückungselement (2) mindestens eine Zenerdiode aufweist, deren Durchbruchspannung mindestens 200 mV höher ist als die Betriebsspannung des zugehörigen Laserdiodenbarrens (1).

8. Laserdiodenbauelement nach Anspruch 2,
**dadurch gekennzeichnet, dass**
das Überbrückungselement (2) ein Triac ist, dessen Schaltspannung mindestens 200 mV höher ist als die Betriebsspannung des zugehörigen Laserdiodenbarrens (1).

9. Laserdiodenbauelement nach mindestens einem der Ansprüche 1 bis 8,
**dadurch gekennzeichnet, dass**
das erste Verbindungsmittel (4) ein Hartlot ist und das zweite Verbindungsmittel (5) in Weichlot ist.

10. Schaltungsanordnung mit einer Mehrzahl von seriell zueinander verschalteten Laserdiodenbarren (1), an denen im Betrieb der Serienschaltung jeweils eine bestimmte Betriebsspannung anliegt, wobei
- jedem Laserdiodenbarren (1) ein Überbrückungselement (2) parallelgeschaltet ist, das bei Anliegen der bestimmten Betriebsspannung am zugehörigen Laserdiodenbarren (1) einen geringeren Strom durchläßt als der Laserdiodenbarren (1) oder keinen Strom durchläßt und das in einen derart niederohmigen Zustand umschaltet, dass der Laserdiodenbarren (1) überbrückt wird, sobald der Spannungsabfall am Laserdiodenbarren (1) die bestimmte Betriebsspannung um einen vorgegebenen Spannungswert überschreitet,
- jeder Laserdiodenbarren (1) und das zugehörige Überbrückungselement (2) auf einer gemeinsamen Wärmesenke (3) aufgebracht sind, und
- das Überbrückungselement (2) mittels eines ersten Verbindungsmittels (4) auf der Wärmesenke (3) befestigt ist und der Laserdiodenbarren (1) mittels eines zweiten Verbindungsmittels (5) auf der Wärmesenke (3) befestigt ist, **dadurch gekennzeichnet, dass** der Schmelzpunkt des ersten Verbindungsmittels (4) bei einer höheren Temperatur liegt als der des zweiten Verbindungsmittels (5).

11. Schaltungsanordnung nach Anspruch 10,
**dadurch gekennzeichnet, dass**
das Überbrückungselement (2) in den den Laserdiodenbarren (1) überbrückenden Zustand umschaltet, sobald die am Überbrückungselement (2) anliegende Spannung mindestens 200 mV höher ist als die bestimmte Betriebsspannung des zugehörigen Laserdiodenbarrens (1).

12. Schaltungsanordnung nach Anspruch 10 oder 11,
**dadurch gekennzeichnet, dass**
das Überbrückungselement (2) mindestens eine Diode aufweist, die bei Anliegen der bestimmten Betriebsspannung an dem zugehörigen Laserdiodenbarren (1) in Durchlassrichtung gepolt ist und deren Diffusionsspannung mindestens 200 mV höher ist als die Betriebsspannung des zugehörigen Laserdiodenbarrens (1).

13. Schaltungsanordnung nach Anspruch 11 oder 12,
**dadurch gekennzeichnet, dass**
das Überbrückungselement (2) eine Diode auf der Basis von AlGaAs-Halbleitermaterial aufweist.

14. Schaltungsanordnung nach Anspruch 11 oder 12,
**dadurch gekennzeichnet, dass**
das Überbrückungselement (2) eine Serienschaltung von mehreren Dioden aufweist.

15. Schaltungsanordnung nach Anspruch 14,
**dadurch gekennzeichnet, dass**
die Serienschaltung drei Si-Dioden aufweist.

16. Schaltungsanordnung nach Anspruch 11,
**dadurch gekennzeichnet, dass**
das Überbrückungselement (2) mindestens eine Zenerdiode aufweist, deren Durchbruchspannung mindestens 200 mV höher ist als die Betriebsspannung des zugehörigen Laserdiodenbarrens (1).

17. Schaltungsanordnung nach Anspruch 11,
**dadurch gekennzeichnet, dass**
das Überbrückungselement (2) ein Triac ist, dessen Schaltspannung mindestens 200 mV höher ist als die Betriebsspannung des zugehörigen Laserdiodenbarrens (1).

18. Schaltungsanordnung nach mindestens einem der Ansprüche 10 bis 17,
**dadurch gekennzeichnet, dass**
das erste Verbindungsmittel (4) ein Hartlot ist und das zweite Verbindungsmittel (5) ein Weichlot ist.

## Claims

1. Laser diode component comprising a laser diode bar (1) at which a specific operating voltage is present during operation, wherein
- a bridging element (2) is connected in parallel with the laser diode bar (1), which bridging element, when the specific operating voltage is present at the associated laser diode bar (1), transmits a smaller current than the laser diode bar (1) or transmits no current and which bridging element changes over to such a low-impedance state that the laser diode bar (1) is bridged as soon as the voltage drop across the laser diode bar (1) exceeds the specific operating voltage by a predefined voltage value,
- the laser diode bar (1) and the associated bridging element (2) are applied on a common heat sink (3), and
- the bridging element (2) is fixed on the heat sink (3) by means of a first connecting means (4) and the laser diode bar (1) is fixed on the heat sink (3) by means of a second connecting means (5),
**characterized in that**
the melting point of the first connecting means (4) is at a higher temperature than that of the second connecting means (5).

2. Laser diode component according to Claim 1,
**characterized in that**
the bridging element (2) changes over to the state that bridges the laser diode bar (1) as soon as the voltage present at the bridging element is at least 200 mV higher than the specific operating voltage of the associated laser diode bar (1).

3. Laser diode component according to Claim 1 or 2,
**characterized in that**
the bridging element (2) has at least one diode which is forward-biased when the specific operating voltage is present at the associated laser diode bar (1) and the diffusion voltage of which is at least 200 mV higher than the operating voltage of the associated laser diode bar (1).

4. Laser diode component according to Claim 2 or 3,
**characterized in that**
the bridging element (2) has a diode based on AlGaAs semiconductor material.

5. Laser diode component according to Claim 2 or 3,
**characterized in that**
the bridging element (2) has a series circuit comprising a plurality of diodes.

6. Laser diode component according to Claim 5,
**characterized in that**
the series circuit has three Si diodes.

7. Laser diode component according to Claim 2,
**characterized in that**
the bridging element (2) has at least one Zener diode, the breakdown voltage of which is at least 200 mV higher than the operating voltage of the associated laser diode bar (1).

8. Laser diode component according to Claim 2,
**characterized in that**
the bridging element (2) is a triac, the switching voltage of which is at least 200 mV higher than the operating voltage of the associated laser diode bar (1).

9. Laser diode component according to at least one of Claims 1 to 8,
**characterized in that**
the first connecting means (4) is a hard solder and the second connecting means (5) is a soft solder.

10. Circuit arrangement comprising a plurality of laser diode bars (1) which are connected up in series with one another and at which a specific operating voltage is in each case present during operation of the series circuit, wherein
- a bridging element (2) is connected in parallel with each laser diode bar (1), which bridging element, when the specific operating voltage is present at the associated laser diode bar (1), transmits a smaller current than the laser diode bar (1) or transmits no current and which bridging element changes over to such a low-impedance state that the laser diode bar (1) is bridged as soon as the voltage drop across the laser diode bar (1) exceeds the specific operating voltage by a predefined voltage value,
- each laser diode bar (1) and the associated bridging element (2) are applied on a common heat sink (3), and
- the bridging element (2) is fixed on the heat sink (3) by means of a first connecting means (4) and the laser diode bar (1) is fixed on the heat sink (3) by means of a second connecting means (5), **characterized in that** the melting point of the first connecting means (4) is at a higher temperature than that of the second connecting means (5).

11. Circuit arrangement according to Claim 10,
**characterized in that**
the bridging element (2) changes over to the state that bridges the laser diode bar (1) as soon as the voltage present at the bridging element (2) is at least 200 mV higher than the specific operating voltage of the associated laser diode bar (1).

12. Circuit arrangement according to Claim 10 or 11,
**characterized in that**
the bridging element (2) has at least one diode which is forward-biased when the specific operating voltage is present at the associated laser diode bar (1) and the diffusion voltage of which is at least 200 mV higher than the operating voltage of the associated laser diode bar (1).

13. Circuit arrangement according to Claim 11 or 12,
**characterized in that**
the bridging element (2) has a diode based on AlGaAs semiconductor material.

14. Circuit arrangement according to Claim 11 or 12,
**characterized in that**
the bridging element (2) has a series circuit comprising a plurality of diodes.

15. Circuit arrangement according to Claim 14,
**characterized in that**
the series circuit has three Si diodes.

16. Circuit arrangement according to claim 11,
**characterized in that**
the bridging element (2) has at least one Zener diode, the breakdown voltage of which is at least 200 mV higher than the operating voltage of the associated laser diode bar (1).

17. Circuit arrangement according to Claim 11,
**characterized in that**
the bridging element (2) is a triac, the switching voltage of which is at least 200 mV higher than the operating voltage of the associated laser diode bar (1).

18. Circuit arrangement according to at least one of Claims 10 to 17,
**characterized in that**
the first connecting means (4) is a hard solder and the second connecting means (5) is a soft solder.

## Revendications

1. Composant à diode laser comprenant une barre de diode laser (1) à laquelle est appliquée une tension de service donnée lors du fonctionnement,
- un élément de pontage (2) étant branché en parallèle avec la barre de diode laser (1) qui, lorsque la tension de service donnée est appliquée à la barre de diode laser (1) correspondante, laisse passer un courant plus faible que la barre de diode laser (1) ou ne laisse passer aucun courant et qui bascule dans un état de faible résistance de telle sorte que la barre de diode laser (1) est pontée dès que la chute de tension aux bornes de la barre de diode laser (1) dépasse la tension de service donnée d'une valeur de tension prédéfinie,
- la barre de diode laser (1) et l'élément de pontage (2) correspondant étant montés sur un dissipateur thermique (3) commun et
- l'élément de pontage (2) étant fixé sur le dissipateur thermique (3) au moyen d'un premier moyen de liaison (4) et la barre de diode laser (1) étant fixée sur le dissipateur thermique (3) au moyen d'un deuxième moyen de liaison (5),
**caractérisé en ce que** le point de fusion du premier moyen de liaison (4) se trouve à une température supérieure à celle du deuxième moyen de liaison (5).

2. Composant à diode laser selon la revendication 1, **caractérisé en ce que** l'élément de pontage (2) bascule dans l'état qui ponte la barre de diode laser (1) dès que la tension appliquée aux bornes de l'élément de pontage est supérieure d'au moins 200 mV à la tension de service donnée de la barre de diode laser correspondante.

3. Composant à diode laser selon la revendication 1 ou 2, **caractérisé en ce que** l'élément de pontage (2) présente au moins une diode qui, lors de l'application de la tension de service donnée à la barre de diode laser (1) correspondante, est polarisée dans le sens passant et dont la tension de diffusion est supérieure d'au moins 200 mV à la tension de service de la barre de diode laser (1) correspondante.

4. Composant à diode laser selon la revendication 2 ou 3, **caractérisé en ce que** l'élément de pontage (2) présente une diode à base de matériau semiconducteur AlGaAs.

5. Composant à diode laser selon la revendication 2 ou 3, **caractérisé en ce que** l'élément de pontage (2) présente un circuit série composé de plusieurs diodes.

6. Composant à diode laser selon la revendication 5, **caractérisé en ce que** le circuit série présente trois diodes au silicium.

7. Composant à diode laser selon la revendication 2, **caractérisé en ce que** l'élément de pontage (2) présente au moins une diode Zener dont la tension inverse est supérieure d'au moins 200 mV à la tension de service de la barre de diode laser (1) correspondante.

8. Composant à diode laser selon la revendication 2, **caractérisé en ce que** l'élément de pontage (2) est un triac dont la tension de commutation est supérieure d'au moins 200 mV à la tension de service de la barre de diode laser (1) correspondante.

9. Composant à diode laser selon au moins l'une des revendications 1 à 8, **caractérisé en ce que** le premier moyen de liaison (4) est un brasage fort et le deuxième moyen de liaison (5) est un brasage tendre.

10. Arrangement de circuit comprenant une pluralité de barres de diode laser (1) branchées en série les unes avec les autres et auxquelles est à chaque fois appliquée une tension de service donnée lors du fonctionnement du circuit série,
- un élément de pontage (2) étant branché en parallèle avec chaque barre de diode laser (1) qui, lorsque la tension de service donnée est appliquée à la barre de diode laser (1) correspondante, laisse passer un courant plus faible que la barre de diode laser (1) ou ne laisse passer aucun courant et qui bascule dans un état de faible résistance de telle sorte que la barre de diode laser (1) est pontée dès que la chute de tension aux bornes de la barre de diode laser (1) dépasse la tension de service donnée d'une valeur de tension prédéfinie,
- chaque barre de diode laser (1) et l'élément de pontage (2) correspondant étant montés sur un dissipateur thermique (3) commun et
- l'élément de pontage (2) étant fixé sur le dissipateur thermique (3) au moyen d'un premier moyen de liaison (4) et la barre de diode laser (1) étant fixée sur le dissipateur thermique (3) au moyen d'un deuxième moyen de liaison (5), **caractérisé en ce que** le point de fusion du premier moyen de liaison (4) se trouve à une température supérieure à celle du deuxième moyen de liaison (5).

11. Arrangement de circuit selon la revendication 10, **caractérisé en ce que** l'élément de pontage (2) bascule dans l'état qui ponte la barre de diode laser (1) dès que la tension appliquée aux bornes de l'élément de pontage (2) est supérieure d'au moins 200 mV à la tension de service donnée de la barre de diode laser (1) correspondante.

12. Arrangement de circuit selon la revendication 10 ou 11, **caractérisé en ce que** l'élément de pontage (2) présente au moins une diode qui, lors de l'application de la tension de service donnée à la barre de diode laser (1) correspondante, est polarisée dans le sens passant et dont la tension de diffusion est supérieure d'au moins 200 mV à la tension de service de la barre de diode laser (1) correspondante.

13. Arrangement de circuit selon la revendication 11 ou 12, **caractérisé en ce que** l'élément de pontage (2) présente une diode à base de matériau semiconducteur AlGaAs.

14. Arrangement de circuit selon la revendication 11 ou 12, **caractérisé en ce que** l'élément de pontage (2) présente un circuit série composé de plusieurs diodes.

15. Arrangement de circuit selon la revendication 14, **caractérisé en ce que** le circuit série présente trois diodes au silicium.

16. Arrangement de circuit selon la revendication 11, **caractérisé en ce que** l'élément de pontage (2) présente au moins une diode Zener dont la tension inverse est supérieure d'au moins 200 mV à la tension de service de la barre de diode laser (1) correspondante.

17. Arrangement de circuit selon la revendication 11, **caractérisé en ce que** l'élément de pontage (2) est un triac dont la tension de commutation est supérieure d'au moins 200 mV à la tension de service de la barre de diode laser (1) correspondante.

18. Arrangement de circuit selon au moins l'une des revendications 10 à 17, **caractérisé en ce que** le premier moyen de liaison (4) est un brasage fort et le deuxième moyen de liaison (5) est un brasage tendre.
